(19) Europäisches Patentamt
European Patent Office
Office européen des brevets

(11) **EP 2 571 045 B1**

(12) **FASCICULE DE BREVET EUROPEEN**

(45) Date de publication et mention
de la délivrance du brevet:
**25.05.2016 Bulletin 2016/21**

(21) Numéro de dépôt: **12173326.5**

(22) Date de dépôt: **25.06.2012**

(51) Int Cl.:
*H01L 21/56* (2006.01)    *H01L 23/24* (2006.01)
*H01L 23/043* (2006.01)    *H01L 23/053* (2006.01)
*H01L 23/31* (2006.01)    *H01L 21/98* (2006.01)
*H01L 25/065* (2006.01)

(54) **Procédé d'hybridation flip-chip pour la formation de cavites hermétiques et systèmes obtenus par un tel procédé**

Flip-Chip-Hybridisierungsverfahren für die Bildung von hermetisch abgeschlossenen Hohlräumen, und durch dieses Verfahren erzielte Systeme

Flip-chip hybridisation method for forming sealed cavities and systems obtained by such a method

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.06.2011 FR 1155913**

(43) Date de publication de la demande:
**20.03.2013 Bulletin 2013/12**

(73) Titulaire: **COMMISSARIAT A L'ENERGIE ATOMIQUE ET AUX ENERGIES ALTERNATIVES 75015 Paris (FR)**

(72) Inventeur: **Marion, François
38950 Saint-Martin le Vinoux (FR)**

(74) Mandataire: **Cabinet Laurent & Charras
Le Contemporain
50 Chemin de la Bruyère
69574 Dardilly Cedex (FR)**

(56) Documents cités:
WO-A1-99/52209          WO-A1-2005/008779
DE-A1- 10 153 211       DE-A1- 19 810 060
DE-A1-102005 037 948    US-B1- 6 391 682

## Description

### DOMAINE DE L'INVENTION

L'invention a trait au domaine de la connexion de deux composants selon la technique d'hybridation face contre face, mieux connue sous l'expression anglo-saxonne *« flip chip ».*

L'invention trouve ainsi particulièrement application dans les assemblages dits « puce sur puce », « puce sur wafer » et « wafer sur wafer ».

### ETAT DE LA TECHNIQUE

L'hybridation *« flip-chip »* est usuellement utilisée pour assembler deux composants microélectroniques fabriqués indépendamment l'un de l'autres, mais fonctionnant de manière complémentaire, comme par exemple une matrice d'éléments unitaires de détection et son circuit de lecture, le plus généralement en réalisant des connexions électro-mécaniques par billes de soudures ou par insertion d'inserts en métal dur dans des plots métalliques ductiles.

Cette hybridation est souvent complétée par le remplissage de l'espace entre les deux composants hybridés par un matériau de protection, usuellement une résine epoxy, cette opération étant connue sous le nom d'« *underfiling* ». On connait par exemple du document DE 198 10 060 un tel procédé.

Le matériau de remplissage permet en effet d'absorber les écarts de dilations thermiques des premier et second composants électroniques qui ne présentent généralement pas le même coefficient de dilation thermique, de protéger les interconnexions entre ces deux composants d'un environnement qui leur est défavorable, comme un environnement humide par exemple, et de fournir une protection mécanique contre les chocs et les vibrations.

Si le matériau de remplissage est donc avantageux à plus d'un titre, il n'est cependant pas applicable à tout type de composants hybridés. En effet, l'un des composants ou les deux composants peuvent également présenter sur leur face des circuits électroniques ne pouvant pas fonctionner s'ils sont noyés dans le matériau de remplissage. On peut par exemple citer les puces électroniques en générale, et les circuits de détection de lumière en particulier, comme les détecteurs bolométriques, ou les circuits de type MEMS (pour l'acronyme anglo-saxon *« Micro Electro Mecanical Systems »*), ou encore certaines connexions électriques.

En outre, certains circuits requièrent spécifiquement une pression réduite ou le vide pour pouvoir fonctionner, comme par exemple les détecteurs bolométriques qui nécessitent un environnement très peu conducteur de la chaleur. Dans de tels cas, l'opération d'« *underfiling »* selon l'état de la technique est alors impossible car cela implique de noyer lesdits circuits.

## EXPOSE DE L'INVENTION

L'un des objets de la présente invention est de proposer un procédé d'assemblage de deux composants microélectroniques qui permette à la fois la réalisation d'une opération d'« *underfiling* » et la création de cavités hermétiques noyées dans le matériau de remplissage utilisé pour l'« *underfiling ».*

A cet effet, l'invention concerne un procédé de fabrication d'un ensemble microélectronique comprenant au moins un premier et un second composants micro-électroniques reportés l'un sur l'autre et entre lesquels est réalisée au moins une cavité hermétique, noyée dans un matériau de remplissage, le procédé consistant :

- à définir ladite cavité au moyen d'une paroi latérale constituant un cadre fermé s'étendant autour d'une zone déterminée du premier composant à l'exception d'une ouverture faisant fonction d'évent ;
- à ménager au sein du cadre fermé et en regard de l'évent un obstacle apte à constituer en coopération avec la paroi latérale une canalisation ou conduite de dérivation pour le matériau de remplissage ;
- à hybrider face contre face les premier et second composants, une face du second composant reposant sur l'extrémité ou bord supérieur de la paroi latérale formée sur le premier composant de manière à former ladite au moins une cavité ;
- à injecter le matériau de remplissage sous forme liquide entre les deux composants hybridés de manière à noyer ladite au moins une cavité et à rendre celle-ci hermétique par obstruction de l'évent en suite de la solidification dudit matériau de remplissage.

Selon l'invention, la longueur de la canalisation ou conduite de dérivation est supérieure à la distance parcourue par le matériau de remplissage entre le moment de la présentation de ce dernier au niveau de l'évent et le moment de la solidification du matériau de remplissage.

Le terme « latéral » se rapporte ici à la direction perpendiculaire aux faces rapportées l'une sur l'autre des premier et second composants.

Le terme « liquide » se rapporte ici à une phase d'un matériau dans laquelle ce dernier peut s'écouler pour remplir l'espace entre les premier et second composants, le matériau pouvant présenter diverses viscosités en fonction de l'application choisie.

En d'autres termes, une cavité est créée en réalisant tout d'abord une « enceinte » extérieure ouverte uniquement au niveau d'un évent qui communique avec la cavité à l'aide d'une conduite de dérivation.

La canalisation ou conduite de dérivation remplit deux fonctions :

- la première fonction, en combinaison avec l'évent, est de laisser la cavité communiquer avec l'extérieur lors de l'opération d'hybridation *« flip-chip »*. En absence de cette communication, c'est-à-dire si la paroi latérale définissant la cavité est entièrement fermée, et donc démunie d'évent, et si l'hybridation *« flip-chip »* n'est pas réalisée sous vide, le report du second composant sur le premier composant peut conduire à une surpression dans la cavité, ce qui fragiliserait mécaniquement l'ensemble hybridé et/ou compromettrait le fonctionnement de certains circuits comme les détecteurs bolométriques et les circuits à base de MEMS (pour « *Micro-Electro Mechanical System* »). Ensuite, lors de certaines hybridations *« flip-chip »*, il est mis en oeuvre un flux de désoxydation pour garantir la qualité des interconnexions électriques, ce qui nécessite de pouvoir évacuer certains dégagement de gaz acides dans la cavité une fois ces interconnexions réalisées, et donc d'avoir un accès aux cavités.

- la seconde fonction est de prévenir la pénétration du matériau de remplissage dans les cavités. En effet, une conduite de dérivation rallonge le parcours du matériau de remplissage entre l'évent et l'intérieur de la cavité, ce qui laisse donc le temps audit matériau de se solidifier en raison du délai d'écoulement du matériau liquide dans la conduite. Il est d'ailleurs à noter que l'opération d' « *underfiling* » nécessite usuellement des matériaux de viscosité faible pour obtenir un remplissage satisfaisant de l'espace séparant les deux composants hybridés. En absence de la conduite de dérivation, le matériau de remplissage sous forme liquide pénètre donc à l'intérieur de la cavité avant qu'il puisse être stoppé par solidification.

Il est également à noter qu'il n'est pas nécessaire de fermer hermétiquement l'évent ménagé au sein de la paroi latérale, par exemple par un point de colle, avant de procéder à l'« *underfiling* », puisque que c'est le matériau de remplissage lui-même qui ferme hermétiquement ledit évent en raison de sa solidification.

Enfin, on comprendra que la forme et la longueur de la conduite de dérivation peuvent être multiples et peuvent être optimisées en fonction, notamment, de la vitesse d'écoulement du matériau de remplissage liquide, et donc de sa viscosité, de sa durée de solidification ou de l'instant de déclenchement de celle-ci. Il est également possible de définir des conduites de dérivation suffisamment longue pour s'assurer que le matériau de remplissage ne pénètre pas dans la cavité avant d'être stoppé par solidification.

On comprendra également que l'hybridation des composants et l'injection de matériau de remplissage ne sont pas nécessairement réalisées dans cet ordre, le matériau de remplissage pouvant par exemple être déposé sur le premier composant avant le report du second composant, puis le second composant reporté.

Selon un mode particulier de réalisation de l'invention, la constitution de la au moins une cavité résulte de la réalisation sur la face dudit premier composant :

- d'une paroi latérale externe formant un cadre fermé à l'exclusion d'un premier évent ;
- et d'une paroi latérale interne par rapport au cadre ainsi réalisé, définissant une conduite de dérivation entre le premier évent et ladite zone.

En d'autres termes, selon cette forme de réalisation, la canalisation ou conduite de dérivation est définie par deux cadres concentriques, ou à tout le moins dans lequel l'un est circonscrit dans l'autre.

Selon un autre mode de réalisation particulier, les parois latérales externe et interne associées à chacune d'au moins une partie ou de la totalité des cavités forment un ensemble d'au moins deux cadres imbriqués autour de la cavité et fermés à l'exclusion d'un évent par cadre, l'évent d'un cadre étant agencé à l'opposé de l'évent du cadre le plus proche le contenant. Cet agencement permet de réduire la surface occupée par la dérivation, tout en ayant des parois latérales définissant une ensemble sensiblement symétrique sur le pourtour de la cavité, impliquant que les contraintes exercées sur celle-ci sont symétriques et s'exercent de manière uniforme lors d'un cycle thermique.

Selon un autre mode de réalisation, les parois latérales externe et interne associées à chacune d'au moins une partie ou de la totalité des cavités forment une conduite en spirale ouverte vers la cavité par un deuxième évent. Pour une même surface de propagation, ce mode de réalisation permet de multiplier par deux le temps de propagation, par exemple par rapport au mode de réalisation précédent.

Selon un mode de réalisation de l'invention, le matériau de remplissage sous forme liquide est un polymère réticulable, par exemple par chauffage ou irradiation, la solidification étant réalisée par réticulation dudit polymère. Notamment, pour un polymère réticulable par irradiation, par exemple UV, la solidification est ainsi très rapide et permet de stopper de manière contrôlée la progression du matériau de remplissage en augmentant la fluence du rayonnement UV. De même, pour un polymère réticulable par chauffage, il est possible de stopper de manière contrôlée la progression si une température supérieure à la température minimale de réticulation du polymère est appliquée, par exemple une température supérieure à 100°C pendant 15 minutes pour une résine époxy.

Selon un mode de réalisation de l'invention, les premiers évents sont réalisés sensiblement au même endroit dans les cadres externes des cavités, et dans lequel le matériau de remplissage est injecté en une localisation opposée aux premiers évents des cavités. Ainsi, il existe un délai entre l'instant d'injection du matériau de remplissage liquide entre les composants hybridés et l'instant de présentation de ce matériau devant les évents des enceintes ou cadres externes des cavités. Ce délai peut alors être mis à profit pour réaliser des opérations particulières, comme par exemple une mise sous vide, ou un changement de plateforme de travail.

Selon un mode de réalisation de l'invention, la longueur des conduites de dérivation est déterminée en fonction de la vitesse d'écoulement du matériau de remplissage sous forme liquide. Ceci permet notamment de minimiser la longueur de la conduite de dérivation, et donc de réduire la surface allouée à chaque cavité et de réduire la quantité de matériau dédiée à la constitution des parois latérales.

Selon un mode de réalisation de l'invention, au moins l'injection de matériau de remplissage est réalisée sous une pression réduite, et par exemple sous vide, ce qui permet d'obtenir des cavités sous pression réduite ou sous vide. En variante, l'injection est réalisée sous atmosphère contrôlée, notamment constituée d'un gaz approprié pour le fonctionnement de certains circuits, comme un gaz rare ou un gaz neutre par exemple.

L'invention a également pour objet un ensemble microélectronique comprenant des premier et second composants microéléctroniques reportés l'un sur l'autre et entre lesquels sont réalisées des cavités hermétiques noyées dans un matériau de remplissage, ledit ensemble étant obtenu conformément à un procédé du type précité.

Selon un mode de réalisation, les cavités hermétiques comprennent des circuits microélectroniques, opto-électroniques, optiques, et notamment des éléments sensibles de détection, des puces électroniques, des circuits de type MEMS ou des connectiques électriques.

Selon un mode de réalisation, le premier composant microélectronique ou le second composant microélectronique est un capot.

## BREVE DESCRIPTION DES FIGURES

L'invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :

- les figures 1 et 2 sont respectivement des vues de dessus et en coupe selon l'axe A-A d'une étape de fabrication de parois latérales sur un substrat comprenant des circuits destinés à être contenus dans des cavités hermétiques, selon l'invention ;
- la figure 3 est une vue en coupe selon l'axe A-A du report d'un capot sur l'ensemble décrit aux figures 1 et 2 ;
- les figures 4 et 5 sont respectivement des vues de dessus et en coupe de l'ensemble hybridé une fois une opération d'underfiling réalisée, le capot étant ici montré en transparence sur la figure 4 ;
- les figures 7 et 8 sont deux exemples de réalisation illustrant deux injections de matériau de remplissage pour l'opération d'underfiling, conformément à l'invention ;
- la figure 9 est une vue de dessus d'une cavité et de sa conduite de dérivation en présence de matériau de remplissage liquide.

## DESCRIPTION DETAILLEE DE L'INVENTION

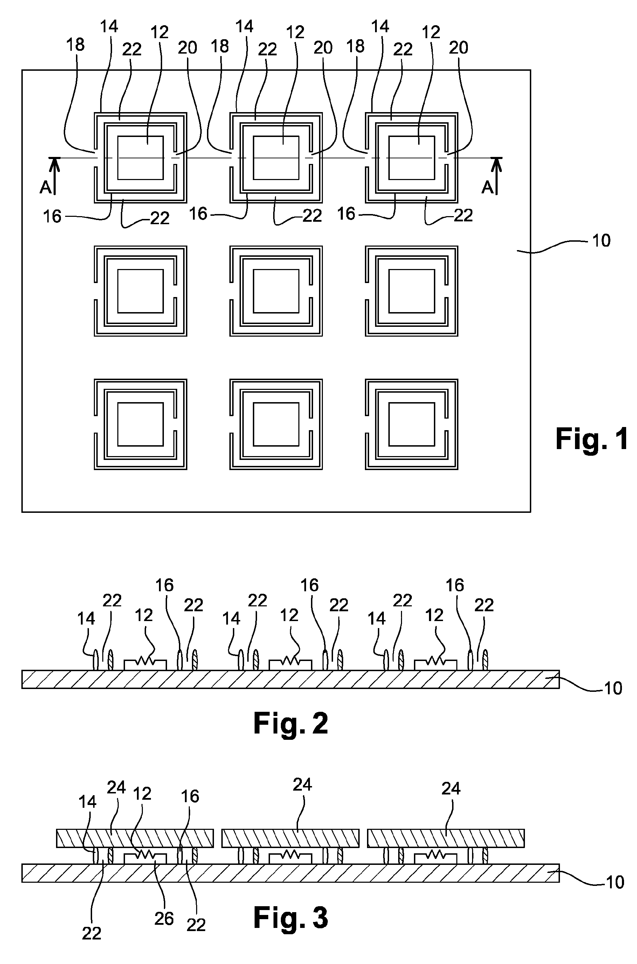

Il va à présent être décrit en relation avec les figures 1 à 6, un procédé d'un mode de réalisation de l'invention, appliqué à la fabrication collective de circuits MEMS, dans les figures par exemple une matrice de trois par trois circuits MEMS.

Un circuit à base de MEMS comporte par exemple un substrat **10** sur lequel ou au dessus duquel sont réalisés des MEMS **12**. Les MEMS **12** nécessitent pour leur fonctionnement d'être placés sous pression réduite, sous vide ou sous atmosphère contrôlée. Pour ce faire, les circuits MEMS sont enfermés dans une cavité hermétique. Les circuits MEMS sont bien connus en soi et ne seront pas décrits plus en détail par la suite. On retreindra simplement la nécessité de fournir des cavités hermétiques enrobées dans un matériau de remplissage lors d'une opération dite d'« *underfiling* ».

Comme cela est visible sur les figures 1 et 2, le procédé débute par la formation de parois latérales **14, 16** autour de chaque circuit MEMS **12** de manière à former :

- un cadre externe **14** fermé à l'exception d'un premier évent **18 ;** et
- un cadre **16,** interne par rapport au cadre externe **14,** fermé à l'exception d'un second évent **20,** le premier évent **18** et le second évent **20** étant placés de part et d'autre du circuit MEMS **12.**

Le cadre externe **14** et le cadre interne **16** définissent ainsi ensemble une conduite de dérivation **22** que tout liquide doit emprunter lors de sa présentation au niveau du premier évent **18** pour pénétrer, par le deuxième évent **20,** dans la zone centrale où est disposé le circuit MEMS **12,** rallongeant de fait la distance d'écoulement, et donc le temps mis par le liquide, pour pénétrer cette zone centrale.

Le procédé se poursuit par l'hybridation d'un capot **24** individuel pour chaque circuit MEMS **12,** de manière à faire reposer le capot **24** sur le bord supérieur des parois latérales **14, 16** et à sceller le capot **24** sur celles-ci. Des cavités **26** sont ainsi formées pour les circuits MEMS **12,** qui sont, à cette étape du procédé, hermétiques sauf en ce qui concerne les premiers évents **18** (figure 3).

Les cadres **14, 16** sont par exemple réalisés en déposant des cordons de matériau de soudure tel qu'utilisé dans les interconnexions électromécaniques par billes de soudure, par exemple de l'indium. L'hybridation des capots **24** met alors par exemple en oeuvre une thermocompression ou une refusion pour solidariser le capot aux parois latérales **14, 16** et ainsi sceller hermétiquement les cavités contenant les circuits MEMS **12.**

En variante, les capost **24** sont par exemple munis d'inserts métalliques pleins ou creux venant s'insérer dans les cordons réalisés en un matériau ductile et déposés sur le substrat **10,** de manière à opérer le scellement des capots **24.** En fonction de l'application, les capots **24** peuvent également réaliser des interconnexions électriques avec les circuits MEMS **12** d'une manière connue en soi.

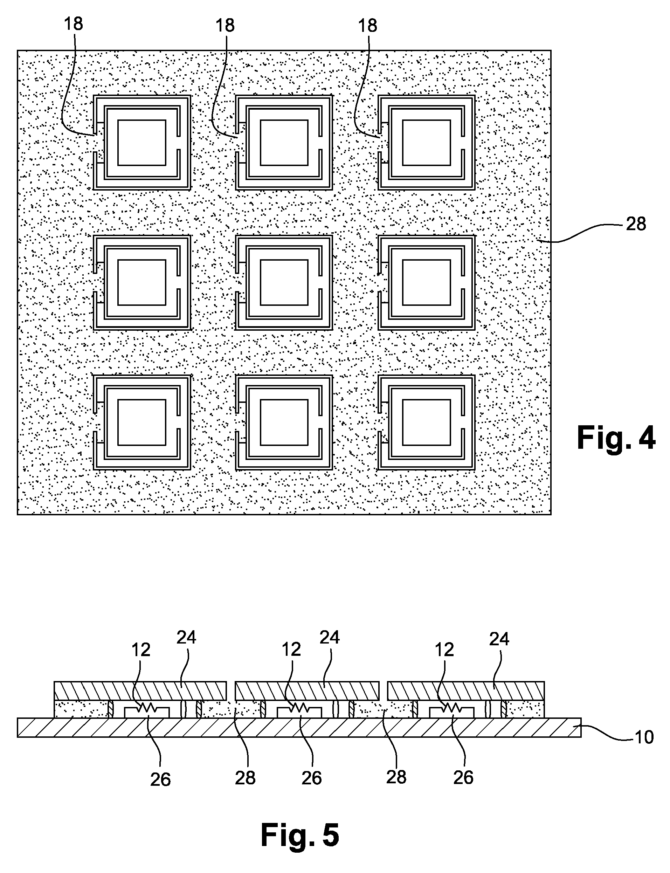

Le procédé se poursuit alors par une étape d'« *underfiling* » (figures 4 et 5). Un matériau de remplissage **28** sous forme liquide, avantageusement un polymère réticulable, par exemple une résine époxy réticulable dans une étuve de réticulation, est injecté entre le substrat **10** et les capots **24.** Le matériau de remplissage **28** s'écoule alors pour remplir entièrement l'espace entre les composants **10, 24** et la solidification dudit matériau **28** est obtenue avant tout pénétration de celui-ci dans les cavités **26.** Lesdites cavités sont ainsi enrobées par le matériau de remplissage **28.** En outre, ce matériau **28** bouche les premiers évents **18** rendant les cavités **26** complètement hermétiques.

En variante, le matériau de remplissage est déposé sous forme liquide sur le composant **10** avant le report des capots **24,** puis ces derniers sont reportés sur les parois **14, 16** au droit des circuits MEMS **12** de manière à ce que le matériau de remplissage soit pris en sandwich entre le composant **10** et les capots **24** afin de permettre une progression par capillarité.

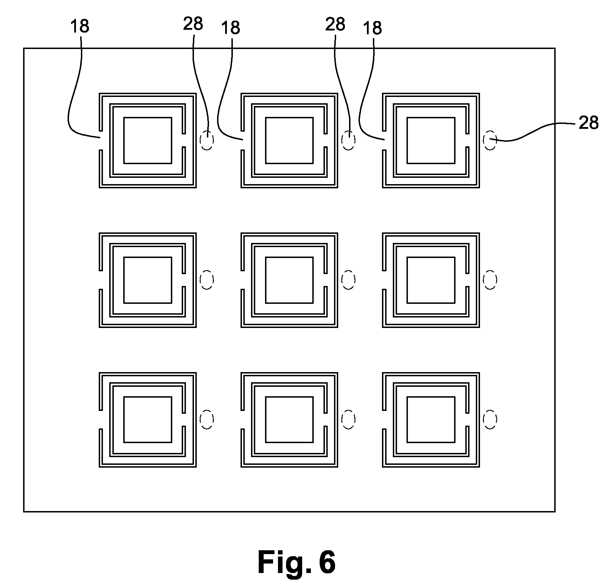

Sur l'exemple de la figure 6, le matériau de remplissage **28** est injecté, avant ou après le report des capots **24,** entre les composants hybridés **10, 24** sous forme d'une goutte pour chaque cavité **26** à l'opposé du premier évent **18** de celle-ci. Le matériau de remplissage **28** progresse alors entre les composants hybridés **10, 24** par capillarité.

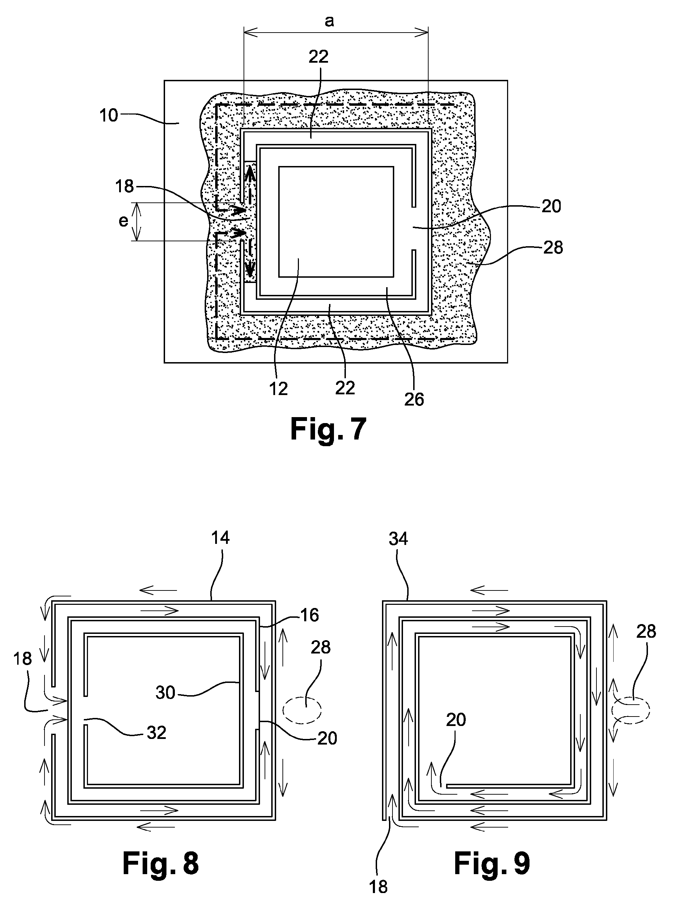

Il va être décrit à présent en relation avec la figure 7 la manière dont est choisie la longueur d'une conduite de dérivation **22** associée à une cavité **26.**

Comme décrit sur cette figure, le matériau de remplissage **28** s'écoule par capillarité depuis son ou ses emplacements d'injection jusqu'à atteindre le premier évent **18** de la cavité **26,** comme cela est illustré par les flèches. Le liquide de remplissage **28** migre alors par capillarité à la vitesse *V* dans la conduite de dérivation **22.** La vitesse $\underline{V}$ est déterminée par les dimensions de la section $\underline{S}$ de la conduite **22,** la viscosité $\underline{\mu}$ du matériau de remplissage **28** et la température $\underline{T}$ de celui-ci. On notera que cette vitesse est aisément calculable ou mesurable sur un dispositif de test pour la conduite, le matériau et la température considérés. Notamment, lorsque ces trois paramètres sont constants, la vitesse $\underline{V}$ d'écoulement dans la conduite **22** est constante.

Ainsi, si $\underline{L}$ est la longueur de la conduite **22** entre le premier évent **18** et le deuxième évent **20,** le matériau de remplissage atteint le deuxième évent **20** $t_{mig} = \dfrac{L}{V}$ secondes après avoir pénétré par le premier évent **18** si rien n'est mis en oeuvre pour le solidifier.

Connaissant par ailleurs la durée nécessaire $\underline{t_{solid}}$ pour solidifier complètement le matériau de remplissage, la longueur de la conduite est par exemple choisie de manière à ce que $t_{solid} < t_{mig}$, soit $L > t_{solid} \times V.$

On notera qu'il est également possible de régler le temps de migration $\underline{t_{mig}}$ en réglant la section $\underline{S}$ de la conduite et/ou la viscosité $\underline{\mu}$ du matériau de remplissage **28.** Il est également possible de régler les dimensions de la conduite **22** en fonction de la durée nécessaire à la solidification du matériau de remplissage. Notamment, des conduites **22** plus courtes et/ou de plus faible section peuvent être choisies si le matériau de remplissage **28** se solidifie plus rapidement.

Il a été décrit un exemple de réalisation particulier selon lequel la conduite de dérivation **22** est réalisée à l'aide de deux cadres imbriqués l'un dans l'autre.

Bien entendu d'autres modes de réalisation sont possibles. Notamment, plus de deux cadres peuvent être imbriquées l'un dans l'autre comme par exemple illustré à la figure 8, dans laquelle trois cadres **14, 16, 30** sont imbriqués l'un dans l'autre avec l'évent d'un cadre positionné à l'opposé de l'évent du cadre directement externe. Ainsi, plus il y de cadres, plus la conduite de dérivation définie par les cadres est longue et plus on dispose de temps entre le moment où le matériau de remplissage est déposé et le moment où le capot est reporté, ce qui présente un avantage lorsqu'on hybride plus d'une centaine de circuits. En effet, lorsqu'un certain nombre de circuits doit être hybridé, il s'écoule un temps « tpd » entre le dépôt de colle sur la première puce et le dépôt de colle sur la dernière puce. On doit s'assurer que la colle reste dans le canal de dérivation, et n'atteigne pas la cavité aussi bien pour la dernière que pour la première puce, cette dernière « voyant » la colle progresser pendant un temps plus long ( = tpd).

De même, comme illustré à la figure 9, une seule paroi **34** enroulée en spirale peut être utilisée pour former le cadre externe et la conduite de dérivation, ce qui permet de former une conduite de dérivation longue sur un minimum de surface.

Il a été décrit une application d'un procédé selon l'invention à la fabrication collective de circuits MEMS. Bien entendu, l'invention s'applique à d'autres types de circuits nécessitant d'être enfermés dans des cavités hermétiques. Par exemple, les circuits peuvent être des circuits de détection infrarouge de type IRCMOS, ou plus généralement tout type d'optiques hermétiques, des détecteurs de gaz, des mini-afficheurs de type OLED, LCD ou autres, des bio-chips, des imageurs ou des émetteurs toutes longueurs d'ondes, des imageurs infrarouge refroidis ou non refroidis, etc...

A titre d'exemple numérique, pour une résine époxy de viscosité égale à 2500 cps à une température ambiante de 20°C, et pour une section $\underline{S}$ constante de la conduite de dérivation égale à 350 micromètres carrés, la vitesse $\underline{V}$ a été mesurée égale à 0,5 millimètre par minute. La durée de solidification complète de cette résine époxy est d'environ 30 minutes dans une enceinte de réticulation à 80°C.

En choisissant une longueur de conduite *L* supérieure à $t_{solid} \times V = 15$ mm, la résine époxy est solidifiée dans les conduites de dérivations **22** avant d'avoir atteint le deuxième évent **20,** c'est-à-dire les cavités hermétiques contenant les circuits.

Pour une matrice de circuits de type précité sensiblement carré et de côté égal à 7,5 millimètres, ce qui correspond par exemple à un circuit de détection de type IRCMOS équipé d'une matrice de 500 éléments unitaires de détection par 500 éléments unitaires de détection au pas de 15 micromètres, on choisit des parois latérales hautes de 7 micromètres, et espacée de 50 micromètres, une section *S* de 350 micromètres carrés est ainsi définie pour les conduites de dérivation **22.**

Dans le mode de réalisation comportant deux cadres imbriqués, comme par exemple illustré de la figure 7, la longueur *L* est égale à *L = 2a - e* lorsque les cadres externe **14** et interne **16** sont carrés de côté égal à *a* avec des premier et second évents de largeur égale à *e*. En choisissant des carrés de côtés égaux à 10 millimètres avec des évents de 2 millimètres, le matériau est stoppé dans la conduite **22** avant de pénétrer dans la cavité **26** puisque la longueur de la conduite est égale à 18 millimètres, soit une distance supérieure aux 15 millimètres que la résine époxy peut parcourir au maximum avec sa solidification complète.

Dans le mode de réalisation comportant une paroi latérale **34** enroulée en spirales carrées de manière à faire deux tours, avec un côté de longueur égale à 10 millimètres, la longueur de la conduite est égale à 40 millimètres, soit encore une longueur bien supérieure aux 15 millimètres précités.

Il a été décrit le report de plusieurs capots individuels. Bien entendu, l'invention s'applique également au report d'un seul capot formé d'une seule pièce.

En outre, il a été décrit une seule étape de dépôt du matériau de remplissage. En variante, le matériau de remplissage est déposé en plusieurs fois, à savoir un premier dépôt pour réaliser les cavités hermétiques, et une ou plusieurs autres dépôts consécutifs pour remplir totalement l'espace entre les composants hybridés si le premier dépôt ne réalise pas le remplissage complet de cet espace.

En outre, la quantité de matériau de remplissage peut également être choisie pour ne pas remplir entièrement l'espace entre les composants hybridés, mais uniquement un volume autour des cavités, ce qui est avantageux si les cavités sont ensuite individualisées car une quantité minimum de matériau de remplissage est utilisée.

**Revendications**

1. Procédé pour la fabrication d'un ensemble microélectronique comprenant au moins un premier (10) et un second (24) composants micro-électroniques reportés l'un sur l'autre et entre lesquels est réalisée au moins une cavité hermétique (26) noyée dans un matériau de remplissage (28), procédé dans lequel :

    - on ménage un obstacle (16) apte à constituer une canalisation ou conduite de dérivation du matériau de remplissage (28) ;
    - on hybride face contre face les premier (10) et second (24) composants ;
    - on injecte le matériau de remplissage (28) sous forme liquide entre les deux composants hybridés de manière à noyer ladite au moins une cavité et à rendre celle-ci hermétique en suite de la solidification dudit matériau de remplissage (28) ;

*caractérisé* **en ce que** ledit procédé consiste en outre :

    - à définir ladite cavité au moyen d'une paroi latérale (14) constituant un cadre fermé s'étendant autour d'une zone déterminée du premier composant (10) à l'exception d'une ouverture faisant fonction d'évent (18) ;
    - à ménager au sein du cadre fermé et en regard de l'évent l'obstacle (16) apte à constituer en coopération avec la paroi latérale la canalisation ou conduite de dérivation (22) du matériau de remplissage ;
    - lors de l'hybridation face contre face du premier (10) et du second (24) composants, à faire reposer une face du second composant sur l'extrémité ou bord supérieur de la paroi latérale formée sur le premier composant de manière à former ladite au moins une cavité (26) ;
    - à obstruer l'évent (18) en suite de la solidification du matériau de remplissage (28) de telle sorte à rendre ladite au moins une cavité hermétique ;

la longueur de la canalisation ou conduite de dérivation (22) étant supérieure à la distance parcourue par le matériau de remplissage (28) entre le moment de la présentation de ce dernier au niveau de l'évent (18) et le moment de la solidification du matériau de remplissage.

2. Procédé pour la fabrication d'un ensemble microélectronique selon la revendication 1, *caractérisé* **en ce que** la constitution de la au moins une cavité (26) résulte de la réalisation sur la face dudit premier composant (10) :

    - d'une paroi latérale externe (14) formant un cadre fermé à l'exclusion d'un premier évent (18) ;
    - et d'une paroi latérale (16), interne par rapport au cadre ainsi réalisé, définissant une conduite

**3.** Procédé pour la fabrication d'un ensemble microélectronique selon la revendication 2, dans lequel les parois latérales externe (14) et interne (16 ; 16, 30) associées à chacune d'au moins une partie ou de la totalité des cavités (26) forment un ensemble d'au moins deux cadres imbriqués autour de la cavité (26) et fermés à l'exclusion d'un évent (18, 20 ; 18, 20, 32) par cadre, l'évent d'un cadre étant agencé à l'opposé de l'évent du cadre le plus proche le contenant.

**4.** Procédé pour la fabrication d'un ensemble microélectronique selon l'une des revendications 2 ou 3, dans lequel les parois latérales externe et interne (34) associées à chacune d'au moins une partie ou de la totalité des cavités (26) forment une conduite en spirale ouverte en direction de la cavité par un deuxième évent.

**5.** Procédé pour la fabrication d'un ensemble microélectronique selon l'une quelconque des revendications précédentes, dans lequel le matériau de remplissage (28) sous forme liquide est un polymère réticulable, la solidification étant réalisée par réticulation dudit polymère.

**6.** Procédé pour la fabrication d'un ensemble microélectronique selon l'une quelconque des revendications précédentes, dans lequel les premiers évents (18) sont réalisés au même endroit dans les cadres externes des cavités (26), et dans lequel le matériau de remplissage (28) est injecté en une localisation opposée auxdits premiers évents (18) de chacun des cavités.

**7.** Procédé pour la fabrication d'un ensemble microélectronique selon l'une quelconque des revendications précédentes, dans lequel la longueur des conduites de dérivation (22) est déterminée en fonction de la vitesse d'écoulement du matériau de remplissage (28) sous forme liquide.

**8.** Procédé pour la fabrication d'un ensemble microélectronique selon l'une quelconque des revendications précédentes, dans lequel au moins l'injection du matériau de remplissage (28) est réalisée sous pression réduite, sous vide ou sous atmosphère contrôlée.

**9.** Procédé pour la fabrication d'un ensemble microélectronique selon l'une quelconque des revendications précédentes, dans lequel ladite zone est destinée à recevoir un composant électronique, optique, opto-électronique ou un MEMS.

**10.** Ensemble microélectronique comprenant des prede dérivation (22) entre le premier évent et ladite zone.

mier et second composants microélectroniques reportés l'un sur l'autre et entre lesquels sont réalisées des cavités hermétiques (26) noyées dans un matériau de remplissage (28), ledit ensemble étant obtenu conformément au procédé selon l'une quelconque des revendications précédentes.

**11.** Ensemble microélectronique selon la revendication 10, dans lequel les cavités hermétiques (26) comprennent des circuits microélectroniques, notamment des éléments sensibles de détection, des circuits de type MEMS ou des connectiques électriques.

**12.** Ensemble selon la revendication 10 ou 11, dans lequel le premier composant microélectronique ou le second composant microélectronique est un capot.

**Patentansprüche**

**1.** Verfahren zur Herstellung einer mikro-elektronischen Einheit, die aus mindestens einem ersten (10) und einem zweiten (24) mikro-elektronischen Bauteil besteht, die gegeneinander versetzt sind und zwischen denen mindestens ein in einem Füllmaterial (28) eingebetteter hermetischer Hohlraum (26) realisiert ist, wobei:

- ein Hindernis (16) ausgespart wird, das in der Lage ist, einen Umleitungskanal oder -leitung für das Füllmaterial (28) darzustellen;
- das erste (10) und zweite (24) Bauteil einander zugewandt hybridisiert werden;
- das Füllmaterial (28) in Form einer Flüssigkeit zwischen den beiden hybridisieren Bauteilen injiziert wird, so dass der genannte, mindestens eine Hohlraum eingebettet wird und aufgrund der Verfestigung des Füllmaterials (28) hermetisch verschlossen wird;

*dadurch gekennzeichnet,* **dass** dieses Verfahren außerdem darin besteht:

- diesen Hohlraum mittels einer Seitenwand (14) zu begrenzen, die einen geschlossenen Rahmen bildet, der sich um eine festgelegte Zone des ersten Bauteils (10) erstreckt, mit Ausnahme einer Öffnung, die als Entlüftungsöffnung (18) dient;
- innerhalb des geschlossenen Rahmens und gegenüber der Entlüftungsöffnung das Hindernis (16) auszusparen, das in Kooperation mit der Seitenwand den/die Umleitungskanal oder -leitung (22) des Füllmaterials bildet;
- bei der Hybridisierung der einander gegenüberliegenden ersten (10) und zweiten (24) Bauteile, eine Seite des zweiten Bauteils auf das Endstück oder das obere Rand der Seitenwand zu stützen, die auf dem ersten Bauteil geformt ist, um diesen mindestens einen Hohlraum (26) zu bilden;

- die Entlüftungsöffnung (18) in Folge der Verfestigung des Füllmaterials (28) so zu verschließen, dass dieser mindestens eine Hohlraum hermetisch geschlossen wird;

Wobei die Länge des/der Umleitungskanals oder -leitung (22) dabei höher ist als der Abstand, den das Füllmaterial (28) zwischen dem Zeitpunkt, zu dem es die Entlüftungsöffnung (18) erreicht, und dem Zeitpunkt der Verfestigung des Füllmaterials (28) durchfließt.

2. Verfahren zur Herstellung einer mikro-elektronischen Einheit gemäß Anspruch *1, dadurch gekennzeichet,* dass die Bildung mindestens eines Hohlraums (26) sich daraus ergibt, dass auf der Vorderseite dieses ersten Bauteils (10):

- eine externe Seitenwand (14), die einen geschlossenen Rahmen bildet, unter Ausschluss einer ersten Entlüftungsöffnung (18);
- und eine Seitenwand (16) realisiert werden, die im Verhältnis zu dem so hergestellten Rahmen innen liegt, und eine Umleitung (22) zwischen der ersten Entlüftungsöffnung und dieser Zone definiert.

3. Verfahren zur Herstellung einer mikro-elektronischen Einheit gemäß Anspruch 2, bei dem die externe (14) und internen Seitenwände (16, 16, 30), wobei jede mit mindestens einem Teil der oder aller Hohlräume (26) verbunden ist, eine Einheit von mindestens zwei ineinander um den Hohlraum (26) geschachtelten und geschlossenen Rahmen bilden, mit Ausnahme einer Entlüftungsöffnung (18, 20, 18, 20, 32) pro Rahmen, wobei die Entlüftungsöffnung eines Rahmens gegenüber der Entlüftungsöffnung des nächsten, sie enthaltenden Rahmens angebracht ist.

4. Verfahren zur Herstellung einer mikro-elektronischen Einheit gemäß einem der Ansprüche 2 oder 3, bei dem die externe und interne Seitenwand (34), wobei jede mit mindestens einem Teil der oder aller Hohlräume (26) verbunden ist, eine in Richtung des Hohlraums über eine zweite Entlüftungsöffnung offene Leitung in Spiralform bilden.

5. Verfahren zur Herstellung einer mikro-elektronischen Einheit gemäß einem der vorhergehenden Ansprüche, bei denen das Füllmaterial (28) in flüssiger Form ein vernetzbares Polymer ist, wobei die Verfestigung durch Vernetzung dieses Polymers erfolgt.

6. Verfahren zur Herstellung einer mikro-elektronischen Einheit gemäß einem der vorhergehenden Ansprüche, bei denen die ersten Entlüftungsöffnungen (18) an der gleichen Stellen in den externen Rahmen der Hohlräume (26) realisiert werden, und bei denen das Füllmaterial (28) an einer Stelle gegenüber den genannten ersten Entlüftungsöffnungen (18) in jeden dieser Hohlräume injiziert wird.

7. Verfahren zur Herstellung einer mikro-elektronischen Einheit gemäß einem der vorhergehenden Ansprüche, bei denen die Länge der Umleitungen (22) in Abhängigkeit von der Fließgeschwindigkeit des Füllmaterials (28) in flüssiger Form festgelegt wird.

8. Verfahren zur Herstellung einer mikro-elektronischen Einheit gemäß einem der vorhergehenden Ansprüche, bei denen zumindest die Injektion des Füllmaterials (28) unter reduziertem Druck, im Vakuum oder in einer kontrollierten Atmosphäre erfolgt.

9. Verfahren zur Herstellung einer mikro-elektronischen Einheit gemäß einem der vorhergehenden Ansprüche, bei denen diese Zone zur Aufnahme eines elektronischen, optischen, opto-elektronischen Bauteils oder eines MEMS vorgesehen ist.

10. Mikro-elektronische Einheit, die erste (10) und zweite (24) mikro-elektronische Bauteile umfasst, die gegeneinander versetzt sind und zwischen denen in einem Füllmaterial (28) eingebettete hermetische Hohlräume (26) realisiert sind, wobei diese Einheit Ergebnis des Verfahrens nach einem der vorhergehenden Ansprüche ist.

11. Mikro-elektronische Einheit gemäß Anspruch 10, bei der die hermetischen Hohlräume (26) mikro-elektronische Schaltkreise, insbesondere empfindliche Sensorgeräte, Schaltkreise vom MEMS-Typ oder elektrische Anschlusstechniken, enthalten.

12. Einheit gemäß Anspruch 10 oder 11, bei der das erste mikro-elektronische Bauteil oder das zweite mikro-elektronische Bauteil eine Abdeckung ist.

## Claims

1. A method for manufacturing a microelectronic assembly comprising at least one first (10) and one second (24) microelectronic components placed one on top of the other and between which is formed at least one tight cavity (26), embedded in a filling material (28), comprising:

- forming an obstacle (16) capable of forming a bypass duct or line (22) for the filling material (28) ;
- performing a flip-chip hybridization of the first (10) and second (24) components,
- injecting the filling material (28) in liquid form between the two hybridized components to embed said at least one cavity and to make it tight as said filling material (28) solidifies;

**characterized in that** said method further comprises :

- defining said cavity by means of a lateral wall (14) forming a closed frame extending around a determined area of the first component (10) except for an opening used as a vent (18);
- forming within the closed frame and opposite to the vent the obstacle (16); capable of forming in cooperation with the lateral wall the by-pass duct or line (22) for the filling material (28) ;
- during performing the flip-chip hybridization of the first (10) and second (24) components, making a surface of the second component resting on the upper edge or end of the lateral wall formed on the first component to form said at least one cavity (26);
- obstructing the vent (18) as said filling material (28) solidifies in order to make the said at least one cavity tight;

the length of the bypass duct or line (22) being greater than the distance traveled by the filling material (28) between its presentation at the level of the vent (18) and the moment when the filling material solidifies.

2. The method for manufacturing a microelectronic assembly of claim 1, wherein the forming of said at least one cavity (26) results from the forming on the surface of said first component (10):of an external lateral wall (14) forming a closed frame, except for a first vent (18);

- and of a lateral wall (16), internal with respect to the frame thus formed, defining a bypass duct (22) between the first vent and said area.

3. The method for manufacturing a microelectronic assembly of claim 2, wherein the external (14) and internal (16; 16, 30) lateral walls associated with each of at least part or all of the cavities (26) form an assembly of at least two frames nested around the cavity (26) and closed except for one vent (18, 20; 18, 20, 32) per frame, the vent of a frame being arranged opposite to the vent of the closest frame containing it.

4. The method for manufacturing a microelectronic assembly of any of claims 2 or 3, wherein the external and internal lateral walls (34) associated with each of at least part or all of the cavities (26) form a spiral-shaped duct opened towards the cavity by a second vent.

5. The method for manufacturing a microelectronic assembly of any of the foregoing claims, wherein the filling material (28) in liquid form is a cross-linkable polymer, the solidification being performed by cross-linking of said polymer.

6. The method for manufacturing a microelectronic assembly of any of the foregoing claims, wherein the first vents (18) are formed at the same location in the external frames of the cavities (26), and wherein the filling material (28) is injected at a location opposite to said first vents (18) of each of the cavities.

7. The method for manufacturing a microelectronic assembly of any of the foregoing claims, wherein the length of the bypass ducts (22) is determined according to the flow speed of the filling material (28) in liquid form.

8. The method for manufacturing a microelectronic assembly of any of the foregoing claims, wherein at least the injection of the filling material (28) is performed under a low pressure, in vacuum, or under a controlled atmosphere.

9. The method for manufacturing a microelectronic assembly of any of the foregoing claims, wherein said area is intended to receive an electronic, optical, optoelectronic component or a MEMS.

10. A microelectronic assembly comprising first and second microelectronic components installed one on top of the other, and between which are formed tight cavities (26) embedded in a filling material (28), said assembly being obtained according to the method of any of the foregoing claims.

11. The microelectronic assembly of claim 10, wherein the tight cavities (26) comprise microelectronic circuits, and especially sensitive detection elements, MEMS-type circuits, or electric connectors.

12. The assembly of claim 10 or 11, wherein the first microelectronic component or the second microelectronic component is a cap.

## Fig. 1

## Fig. 2

## Fig. 3

**Fig. 4**

**Fig. 5**

**Fig. 6**

**Fig. 7**

**Fig. 8**

**Fig. 9**

**RÉFÉRENCES CITÉES DANS LA DESCRIPTION**

**Documents brevets cités dans la description**

- DE 19810060